# EUROPÄISCHE PATENTSCHRIFT

(11) **EP 0 880 209 B1**
(45) Veröffentlichungstag und Bekanntmachung des Hinweises auf die Patenterteilung: **26.02.2003**
(21) Anmeldenummer: 98109442.8
(22) Anmeldetag: 25.05.1998
(51) Int. Cl.: H02G 3/08, H02G 3/10

(54) **Installationseinrichtung**
Installation device
Dispositif d'installation

(30) Priorität: 23.05.1997 DE 19722103
(43) Veröffentlichungstag der Anmeldung: 25.11.1998
(73) Patentinhaber: Müller, René, 42781 Haan (DE); Müller, Dirk, 47803 Krefeld (DE)
(72) Erfinder: Müller, René, 42781 Haan (DE); Müller, Dirk, 47803 Krefeld (DE)
(74) Vertreter: Ackmann, Günther, Dr.-Ing.

(56) Entgegenhaltungen:
- DE-A- 19 502 257
- US-A- 4 949 376
- US-A- 5 673 016

## Beschreibung

Die Erfindung betrifft eine Installationseinrichtung, insbesondere für eine dezentrale Gebäudetechnik, mit zumindest einer Signalaufnahme- und Informationseinheit und zumindest einer Signalempfangs- und Steuerungseinheit, zwischen denen ein Signalaustausch stattfindet.

Installationseinrichtungen in Wohn-, Industrie- und Geschäftshäusern bestehend seit Jahrzehnten aus voneinander getrennten Installationseinrichtungen, beispielsweise sanitären Wasserversorgungs- und Entsorgungsanlagen, Heizungsanlagen und elektrischen Versorgungseinrichtungen. Während die elektrischen Versorgungseinrichtungen bisher lediglich für eine ausreichende Versorgung mit Steckdosen, Beleuchtungskörperanschlüssen und Schaltern vorgesehen waren, steht im modernen Wohnungsbau immer mehr der Wunsch im Vordergrund, eine zentrale oder dezentrale Steuerung der vorhandenen Lichtanlagen, der Heizungstechnik und Brauchwasseraufbereitung etc. vorzunehmen. Im Weiteren besteht der Bedarf auch vorhandene Alarmanlagen, Personenzugangskontrollen oder weitere Steuerungsmaßnahmen, beispielsweise für Markisen, Jalousien, Rolladen oder Lüftung mit Wärmerückgewinnung, in die gesamte Haustechnik mit aufzunehmen. Ferner wurde die Energietechnik weiterentwickelt und es sollen natürliche Energiequellen, zum Beispiel Solarenergie oder Wännepumpen, mit zur Energieversorgung eines Hauses beitragen, so daß ein nicht unwesentlicher Beitrag zum aktiven Umweltschutz geleistet werden kann. Unter Berücksichtigung dieser Aspekte ist die herkömmliche, voneinander getrennte Installationstechnik nicht mehr zeitgemäß und es müssen neue Wege beschritten werden. Eine Verknüpfung der verschiedenen Meßwertaufnehmer, beispielsweise Temperatursensoren, Raumüberwachungssensoren und Außentemperaturfühlern, mit der bereits vorhandenen Technik in Form von Heizkesselsteuerungen, Brauchwassersteuerungen und der vorhandenen Lichtanlagensteuerung benötigen ein zentrales oder dezentrales Gebäudeleitsystem, welches einen Informationsaustausch in nahezu allen Räumen ermöglicht. Darüber hinaus muß ein Höchstmaß an Flexibilität gegeben sein, um mit den modernen Bedürfnissen Schritt halten zu können.

Ein Teil der Installationseinrichtungen besteht aus den Signalgebern, beispielsweise im Haus vorhandenen Schaltereinrichtungen, welche im einfachsten Fall zum Einschalten des Lichtes oder aber zur Steuerung der Jalousien, des Garagentores etc. eingesetzt werden. Die herkömmlichen Schalter sind dafür vorgesehen, daß sie die vorhandene Netzspannung von 220 Volt zum jeweiligen Endverbraucher leiten, wobei eine Vielzahl von unterschiedlichen Schalterfunktionen und Schaltungsanordnung existiert, welche die Steuerung der Lichtquellen bzw. sonstigen Funktionen von mehreren Positionen aus ermöglichen. Neben diesen eigenständigen Versorgungsnetz existieren ggfs. weitere hiervon unabhängige Verkabelungen, welche beispielsweise eine Raumüberwachung vornehmen oder aber zur Steuerung der Heizungsanlage die Innen- und Außentemperatur übermitteln. Zur Installation dieser Geräte ist daher ein sehr großer Aufwand erforderlich, um die auszuführende Schaltfunktion vom Signalgeber oder den Sensoren auf die Endgeräte zu übertragen. Ferner besteht unter Berücksichtigung der vorhandenen Wohnqualität ein Bedürfnis, die technischen Einrichtungen möglichst nicht in Erscheinung treten zulassen, sondern dezent, unauffällig und auf eine möglichst geringe Anzahl von Einzelelementen zu begrenzen. Aufgrund der unterschiedlichen Spannungen für die einzelnen unabhängigen Installationseinrichtungen ist jedoch allein aus Sicherheitsgründen eine kombinierte Verwendung der Signalgeber in der jetzigen Form nicht möglich.

Der Erfindung liegt die Aufgabe zugrunde, eine Installationseinrichtung zu schaffen, welche einen unproblematischen Austausch der vorhandenen Schaltereinrichtungen unter gleichzeitiger Erhöhung der Flexibilität und gemeinsamen dezentralen Steuerung der unabhängigen Installationseinrichtungen ermöglicht.

Erfindungsgemäß ist zur Lösung der Aufgabe vorgesehen, daß wenigstens die Signalaufnahme- und Informationseinheit unter Beibehaltung der herkömmlichen Abmessungen von Unterputz-Schalterabdeckungen zur Aufputzmontage vorgesehen ist.

Durch die Beibehaltung der Abmessungen der Unterputz-Schalterabdeckungen und die entsprechende Verkleinerung der Signalaufnahme- und Informationseinheiten besteht die Möglichkeit einer kostengünstigen Aufputzmontage unter gleichzeitiger Verwendung der bisherigen modifizierten Schalterabdeckungen. Ferner wird durch die erfindungsgemäßen Signalaufnahme- und Informationseinheiten eine wesentlich erleichterte Montagemöglichkeit geschaffen, weil keine Unterputzdosen mehr erforderlich sind und lediglich ein Anschrauben auf der vorhandenen Wandfläche notwendig ist. Besonders vorteilhaft können diese Installationseinrichtungen in Gebäuden verwendet werden, bei denen keine ausreichende Wandstärke vorhanden ist oder aber eine Schwächung der Wandelemente nicht möglich ist. Ferner wird durch die erleichterte Montage der Arbeitsaufwand erheblich reduziert und die nachträgliche Erweiterung bzw. die Ausführung von Änderungsarbeiten wesentlich erleichtert. Darüber hinaus können durch den Einsatz modernster Elektronikkomponenten vielfältige Funktionsmöglichkeiten auf kleinstem Raum integriert und die einzelnen Signalaufnahme- und Informationseinheiten vielseitig eingesetzt werden und beispielsweise entgegen der bisherigen Verdrahtungstechnik über ein BUS-System miteinander verbunden sein, so daß die verschiedenen Steuerungsvorgänge innerhalb eines Gebäudes dezentral und systemübergreifend interoperabel miteinander vernetzt werden. Ein weiterer wesentlicher Vorteil ergibt sich dadurch, daß durch die erfindungsgemäßen Installationseinrichtungen die Technik nicht in den Vordergrund tritt, sondern dezent einer jeden Raumausstattung angepaßt werden kann und somit optisch kaum wahrgenommen wird. Ein weiterer wesentlicher Vorteil ergibt sich beispielsweise bei der Installation in Fertig- oder Holzhäusern, welche eine unzureichende Wandstärke aufweisen und in der Regel eine Aufputzmontage erfordern. Durch die neuartigen Signalaufnahme- und Informationseinheiten besteht somit die Möglichkeit den Charakter eines an sich normalen Wohngebäudes zu erhalten und den Ansprüchen eines jeden Raumausstatters gerecht zu werden, wobei gleichzeitig modernste Technik eingesetzt wird.

In weiterer Ausgestaltung der Erfindung ist vorgesehen, daß die Bauteile der Signalaufnahme- und Informationseinheiten zumindest auf einer unterhalb der Schalterabdeckung befestigten Platine oder innerhalb eines kompakten Bauteils, z.B. der Hybridtechnik, angeordnet sind. Durch die Integration der verschiedenen Bauteile auf einer vorgefertigten Platine, welche innerhalb der Schalterabdeckung montiert ist, können die erfindungsgemäßen Signalaufnahme- und Informationseinheiten werksmäßig vollständig vormontiert werden, so daß vor Ort nur ein äußerst geringer Montageaufwand notwendig ist.

Um mehrere Installationseinrichtungen an einer Montagestelle untereinander verbinden zu können, ist im weiteren vorgesehen, daß mehrere nebeneinander- oder übereinanderliegende Signalaufnahme- und Informationseinheiten oder mehrere Signalempfangs- und Steuerungseinheiten untereinander durch Steckkontakte miteinander verbunden sind, welche in Form einer Steck- bzw. Buchsenkontaktleiste an zwei diametral gegenüberliegenden Seitenkanten in der Ebene der Platinen angeordnet sind. Hierdurch besteht beispielsweise in Verbindung mit einer entsprechenden BUS-Technik die Möglichkeit mehrere der Installationseinheiten miteinander zu verbinden und beispielsweise in einer Mehrfach-Schalterabdeckung unterzubringen, wobei die Aufputzmontage beibehalten wird. In vorteilhafter Weise werden in diesem Fall die Steck- bzw. Buchsenkontaktleisten derart angebracht, daß die einzelnen Signalaufnahme- und Informationseinheiten oder Signalempfangs- und Steuerungseinheiten horizontal oder vertikal zusammensteckbar ausgebildet sind.

Ein weiterer wesentlicher Vorteil, insbesondere bei Fertig- und Holzhäusern ist dadurch gegeben, daß die Signalaufnahme- und Informationseinheiten ausschließlich mit Niederspannung betreibbar sind. Durch den Einsatz der Niederspannung für die Signalaufnahme- und Informationseinheiten wird der Sicherheitsaspekt der Installationseinrichtung für das gesamte Gebäude wesentlich erhöht, welche insbesondere bei Fertig- und Holzhäusern besonders zu beachten ist. Ferner erfolgt durch den Einsatz der Niederspannungen eine erhebliche Reduzierung des vorhandenen Elektrosmog innerhalb eines Gebäudes. In Verbindung mit der Niederspannung und ggfs. durch den Einsatz einer BUS-Technik innerhalb des Gebäudes wird im Falle von unsachgemäßer Installation oder durch sonstige unvorhersehbare Ereignisse die Gefahr bei Berührung der Signalaufnahmeund Informationseinheiten auf ein Minimum reduziert, während die Signalempfangsund Steuerungseinheiten für den Benutzer unzugänglich angeordnet werden können. Die Netzspannung braucht in diesem Fall lediglich an den zu schaltenden Endgeräten, beispielsweise der Beleuchtungsanlage, herangeführt zu werden, so daß sich im Weiteren auch hier der Installationsaufwand erheblich reduziert.

In weiterer besonderer Ausgestaltung der Erfindung ist vorgesehen, daß die Bauteile der Signalaufnahme- und Informationseinheiten auf einer ersten Platine zur Wandmontage innerhalb der Schalterrahmenabdeckung und einer zweiten Platine unterhalb der Schalterabdeckung angeordnet sind, welche durch zumindest eine, vorzugsweise vier in den Eckpunkten angeordneten, Steckkontaktleisten bzw. Buchsenleisten miteinander verbunden sind, wobei die Steckkontaktleisten und korrespondierenden Buchsenkontaktleisten senkrecht zur jeweiligen Platine angeordnet sind. Durch diese Zweiteilung der Platinenanordnung innerhalb der Schalterabdeckungen mit einer leichten Aufsteckmöglichkeit der eigentlichen Schalterfläche oder einer sonstigen Signalaufnahme- und Informationseinheit braucht das Unterteil mit dem Schalterabdeckrahmen lediglich auf die Wand aufgeschraubt zu werden und die Schalterabdeckung in die vorhandenen Steckkontaktleisten bzw. Buchsenleisten eingedrückt zu werden. Diese Art der Ausführung mit zwei getrennten Platinen ist besonders vorteilhaft, wenn die Installationseinrichtungen durch ein leitungsgebundenes BUS-System im Weiteren mit Niederspannungsleitungen verbunden werden müssen, weil zunächst die untere Platine auf der Wand befestigt werden kann und die Verdrahtung erfolgt, bevor die Schalterabdeckung mit der weiteren Platinenkomponente aufgesteckt wird. Im Falle einer Fehlersuche oder Überprüfung kann durch Abziehen der Schalterabdeckung ggfs. der Fehler bereits einfach und schnell lokalisiert werden.

In weiterer Ausgestaltung der Erfindung ist vorgesehen, daß die Signalaufnahmeund Informationseinheit wenigstens eine programmierbare Mikroprozessorschaltung aufweist, welche zur Erfassung, Anzeige und Weiterleitung von Meßwert-, Steuer-, optischen und akustischen Informations-, und/oder Überwachungssignale sowie zur Auswertung der vorhanden Signale vorgesehen ist. Durch den Einsatz eines modernen Mikroprozessors in einer jeden Signalaufnahme- und Informationseinheit besteht die Möglichkeit mehrere Funktionen durch eine einzelne Einheit ausführen zu lassen und darüber hinaus eine dezentrale Steuerung der gesamten Gebäudetechnik zu ermöglichen, wobei über eine vorhandene BUS-Struktur eine bereichsübergreifende Kontrollmöglichkeit und Steuerungsmöglichkeit gegeben ist.

In weiterer Ausgestaltung der Erfindung ist vorgesehen, daß die Signalaufnahmeund Informationseinheiten aus Schaltern, insbesondere Geräteschaltern, Informationsdisplays, Raumtemperatur-, Klimareglern, Personenruf- und Meldeeinrichtungen, Alarmanlagensensoren oder -gebern, Buseingängen, Sensoren, Dimmern, Anschlußdosen, Zählwerken oder Personenindentifikationsgeräten besteht und daß die Signalempfangs- und Steuerungseinheit zum Anschluß an Heizungsund Brauchwasseranlagen, Lüftungsanlagen mit Wärmerückgewinnung, Solar-, Licht-, Alarmanlagen, Schwimmbadsteuerungen, technische Nutzgeräte sowie akustischen oder optischen Warn- und Meldeeinrichtungen vorgesehen ist.

Um die Funktionen der herkömmlichen Schaltertechnik beizubehalten und den optimalen Einsatz der Mikroprozessor gesteuerten Schaltung zu ermöglichen ist ferner vorgesehen, daß eine Signalaufnahme- und Informationseinheit einer oder mehreren Signalempfangs- und Steuerungseinheiten zugeordnet ist und/oder daß eine Signalempfangs- und Steuerungseinheit einer oder mehreren Signalaufnahmeund Informationseinheit zugeordnet ist. Durch die wahlweise Möglichkeit der Zuordnung von Signalaufnahme- und Informationseinheiten und Signalempfangs- und Steuerungseinheiten besteht beispielsweise die Möglichkeit von mehreren Räumen oder Positionen gleiche Steuerungsvorgänge zu veranlassen, wobei im weiteren auch mehrere Betriebsgeräte, beispielsweise Lichtanlagen, durch eine einzige Signalaufnahme- und Informationseinheit gesteuert werden können. Durch den Einsatz der Mikroprozessortechnik besteht darüber hinaus die Möglichkeit, daß eine individuelle und veränderbare Programmierung der Zuordnung zwischen einer Signalaufnahme- und Informationseinheit und einer Signalempfangs- und Steuerungseinheit möglich ist. Eine einmal getroffene Zuordnung der Signalaufnahme- und Informationseinheiten und der Signalempfangs- und Steuerungseinheiten kann jederzeit und ohne großen Schaltungsaufwand verändert werden, so daß die Gebäudetechnik einerseits schnell an neue Gegebenheiten angepaßt werden kann und andererseits ein Höchstmaß an Flexibilität aufweist.

Um einen Signal- und Datenaustausch zwischen den Signalaufnahme- und Informationseinheiten sowie den Signalempfangs- und Steuerungseinheiten zu gewährleisten ist in weiterer Ausgestaltung der Erfindung vorgesehen, daß die weiter voneinander entfernten Signalaufnahme- und Informationseinheiten sowie Signalempfangs- und Steuerungseinheiten über eine Draht-, Funk- oder Infrarotverbindung, ein Glasfaserkabel oder eine Power-Line untereinander verbunden sind, wobei unter Power-Line eine Signalverbindung über die Netzleitungen zu verstehen ist. Eine Funk- und Infrarotverbindung ist besonders vorteilhaft bei einer späteren Aufrüstung der vorhandenen Gebäudetechnik oder zur weiteren Reduzierung des Montageaufwandes, weil in diesem Fall auf Leitungsverbindungen ganz verzichtet werden kann. Bei einer Neu- oder Erstinstallation kann auf die bewährte Drahtverbindung zurückgegriffen werden, welche jedoch im Bereich der Signalempfangs- und Steuerungseinheiten nur für eine Niederspannung ausgelegt zu werden braucht und darüber hinaus in herkömmlicher Verdrahtung erfolgen kann.

In besonderer Ausgestaltung der Erfindung ist vorgesehen, daß die weiter voneinander entfernten Signalaufnahme- und Informationseinheiten sowie Signalempfangs- und Steuerungseinheiten über einen, vorzugsweise 2-adrigen seriellen, LON-BUS (Local Operating Network) miteinander verbunden sind und über ein standardisiertes LONTALK-Protokoll Daten und Signale austauschen. Der LON-BUS für eine dezentrale Steuerungsanlage unter Verwendung eines standardisierten LONTALK-Protokolls gewährleistet eine ausreichende Flexibilität bei der Erstinstallation und beim späteren Nachrüsten von Gebäuden, weil mit geringen Leitungsaufwand, das heißt lediglich 2-adrigen Leitungen, eine dezentrale Gebäudeleittechnik aufgebaut werden kann, wobei die Signalaufnahme- und Informationseinheiten über Anschlußeinrichtungen, insbesondere den vorhandenen LON-BUS-Verbindungen, mit Computeranlagen und/oder Telefon- bzw. Datennetzen verbindbar sind. Durch die Telefon- bzw. Datennetze besteht darüber hinaus die Möglichkeit einen Fernservice, d. h. zum Beispiel von einem anderen Gebäude aus, durchzuführen. Um eine ausreichende Spannungsversorgung innerhalb des LON-BUS zu gewährleisten und eine beliebige Leitungslänge zu ermöglichen ist vorgesehen, daß der LON-Bus zumindest ein Spannungsversorgungsmodul und/oder zumindest einen BUS-Verstärker aufweist.

Zusammenfassend kann festgestellt werden, daß durch die neuartigen Installationseinrichtungen modernste Mikroprozessortechnik in der Gebäudetechnik eingesetzt werden kann, unter gleichzeitiger Reduzierung des Montageaufwandes und einer wesentlichen Erhöhung der Flexibilität hinsichtlich späterer Änderungen, Ergänzungen oder nachträglicher Verbesserungen innerhalb des Gebäudes, welche darüber hinaus systemübergreifend zu einer komplexen Steuerung von der Haustechnik über die Lichttechnik bis hin zu einer Überwachung des Gebäudes führen kann. Soweit die Technik auch in öffentlichen oder industriellen Gebäuden eingesetzt wird, besteht darüber hinaus die Möglichkeit akustische und optische Meldeeinrichtungen einzusetzen und Personenzugangskontrollen zu ermöglichen, so daß bestimmte Gebäudeteile auch nur von den legitimierten Personen betreten werden können.

Die Erfindung wird im Weiteren anhand der Figuren näher erläutert.

Es zeigt
- Figur: 1 eine Draufsicht und eine geschnittene Seitenansicht einer erfindungsgemäßen Schaltereinheit,
- Figur 2: eine geschnittene Seitenansicht der Schaltereinheit gemäß Figur 1 nach einer Aufputzmontage,
- Figur 3: eine beispielhafte Ausführung einer unteren Baugruppe,
- Figur 4: eine beispielhafte Ausführung einer oberen Baugruppe und
- Figur 5: in einer perspektivischen Ansicht die beiden zusammengesteckten Baugruppen gemäß Figur 3 und 4 und
- Figur 6: ein Blockschaltbild der Baugruppen.

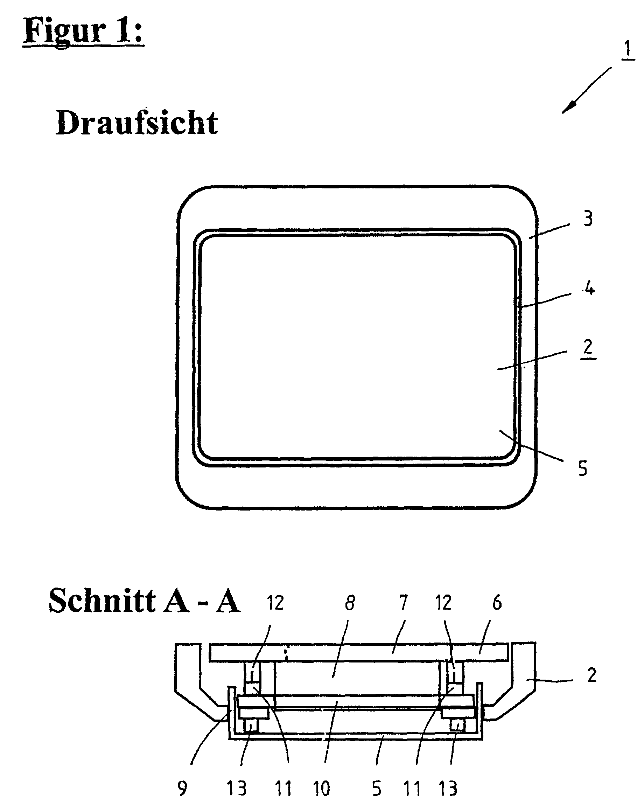

Figur 1 zeigt in einer Draufsicht und in einer geschnittenen Seitenansicht eine Signalaufnahme- und Informationseinheit 1, welche beispielhaft als Flächenschalter 2 dargestellt ist. In der Draufsicht ist einerseits eine rechteckförmige Unterputz-Schalterabdeckung 3 mit einer rechteckförmigen Aussparung 4 und mit einer beweglichen Wippe 5 dargestellt, wobei die Wippe 5 in der rechteckförmigen Aussparung 4 mit Spiel eingesetzt ist. Der innere Aufbau der Signalaufnahme- und Informationseinheit 1 ist im Weiteren aus der geschnittenen Darstellung ersichtlich. Innerhalb der Unterputz- Schalterabdeckung 2 ist eine erste Platine 6 angeordnet, welche beispielsweise auf die zu montierende Wand aufgeschraubt wird. Die Platine 6 verfügt im Weiteren über eine Aussparung 7, die rechteckförmig oder aber auch rund ausgeführt sein kann und die Möglichkeit der Kabelzugführung von unten bietet. Die Kabel werden im Weiteren in einer Klemmleiste 8 befestigt, welche auf der Platine 6 aufgelötet ist. Die Wippe 5 ist schwenkbeweglich innerhalb der Unterputz-Schalterabdeckung 2 gelagert und weist einen umlaufenden Kragen 9 auf, zwischen dem eine zweite Platine 10 befestigt ist, die die weiteren Komponenten der Signalaufnahme- und Informationseinheiten aufnimmt. Es ist jedoch auch denkbar, daß anstelle zweier Platinen nur eine einzelne Platine verwendet wird. Die beiden Platinen 6 und 10 sind über Steckkontakt- und Buchsenleisten 11, 12 miteinander verbunden, welche senkrecht auf der jeweiligen Platine 6, 10 angeordnet sind. Die Steckkontakt- und Buchsenleisten 11, 12 ermöglichen einerseits die Befestigung der beweglichen Wippe 5 auf der unteren Platine 6 und andererseits über eine Vielzahl von Einzelkontakten gleichzeitig die notwendigen elektrischen Verbindungen. Auf der Rückseite der Platine 10 sind zumindestens zwei oder vier Taster 13 aufgelötet, welche bei einer Betätigung der Wippe 5 ansprechen.

Die gezeigte Anordnung einer Signalaufnahme- und Informationseinheit 1 ist von der Funktion und der Gestaltung nur beispielhaft anzusehen, weil ohne weiteres die gezeigte Wippe 5 durch beispielsweise Sensorflächen, Informationsdisplays, Regeleinheiten, Dimmem oder dergleichen ausgetauscht werden kann. Darüber hinaus besteht die Möglichkeit die Wippe 5 auch zweigeteilt auszuführen, um mehrere Schaltfunktionen durch eine Signalaufnahme- und Informationseinheit 1 zu ermöglichen.

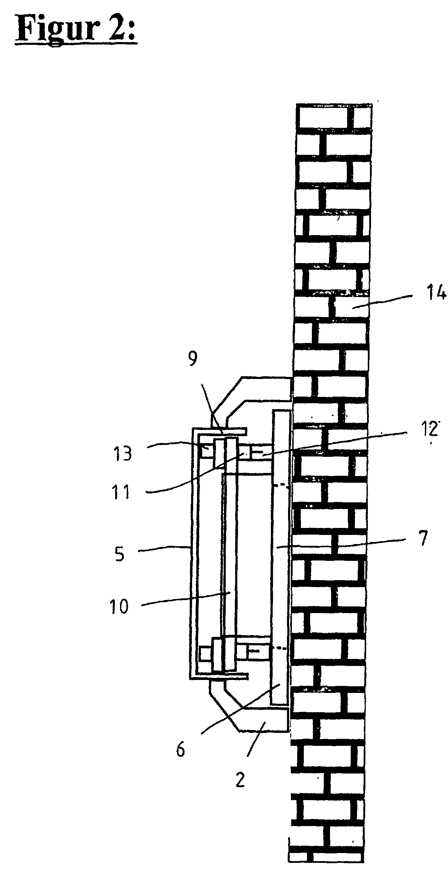

Figur 2 zeigt die erfindungsgemäße Signalaufnahme- und Informationseinheit 1 nochmals in einer geschnittenen Darstellung im Montagezustand auf einer Wand 14. Die Ausführung der Signalaufnahme- und Informationseinheit 1 entspricht derjenigen aus Figur 1. Der Vorteil dieser Montageart liegt darin, daß von außen betrachtet der Schalter sich als normaler Unterputzschalter darstellt, aber lediglich als Aufputzschalter eine Montage erfolgt. Hierdurch entfallen vielfältige und unnütze Arbeiten, wie beispielsweise Elektro-, Stemm-, Schlitz-, Maurer-, Malerarbeiten und deren Folgeaufwand. Die erfindungsgemäßen Signalaufnahme- und Informationseinheiten 1 werden lediglich mit ihrer unteren Platine 6 und eventuellen Isolationsmitteln auf die vorhandene Wand aufgeschraubt und die Unterputz-Schalterabdeckungen 2 zusammen mit der Wippe 5 und der oberen Platine 10 werden mittels der Steckkontakt- und Buchsenleisten 11, 12 auf die untere Platine 7 aufgesteckt. Vor dem Aufstecken kann die untere Platine 7 ggfs. mit den bereits vorhandenen Leitungen verbunden werden oder aber es wird auf eine Leitungsführung verzichtet und über eine Funk- oder Infrarotverbindung der Austausch der erforderlichen Signale und Daten vorgenommen.

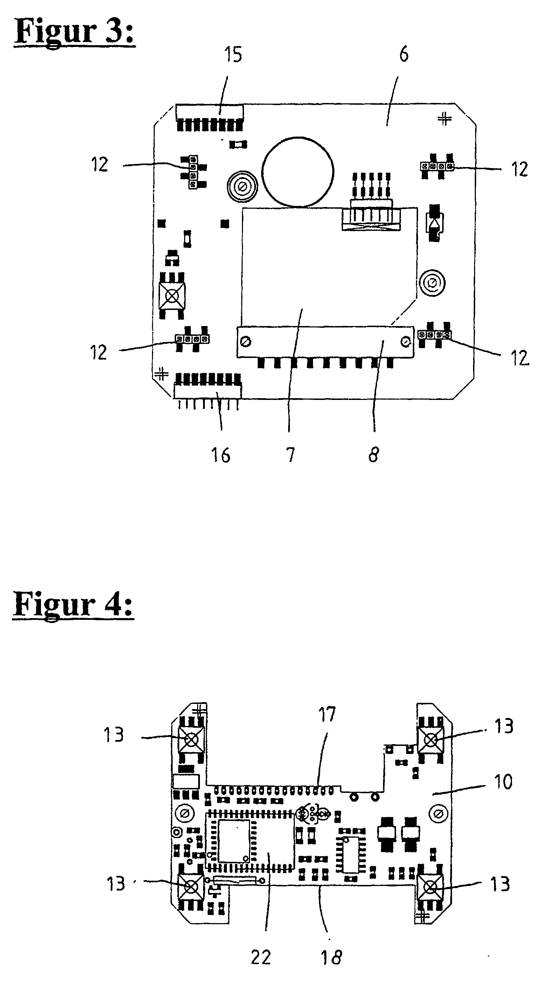

Figur 3 zeigt in einer Draufsicht die untere Platine 6 mit ihrer Aussparung 7, durch welche hindurch ggfs. die Kabel geführt werden können und in den Schraubklemmen 8 befestigt werden. Auf der Platine 6 befinden sich im Weiteren neben einer Vielzahl von elektronischen Bauelementen, die Buchsenleisten 12, welche in der Nähe der Platineneckpunkte angeordnet sind. Um zu vermeiden, daß die obere Platine verkehrt aufgesetzt wird, sind drei der Buchsenleisten 12 horizontal ausgerichtet und eine vierte vertikal. Darüber hinaus befinden sich auf den beiden gegenüberliegenden Seitenkanten und zwar der oberen und unteren Seitenkante eine weitere Steckkontaktleiste 15 und Buchsenleiste 16. Die zuletzt genannten Steckkontakt- und Buchsenleiste 15, 16 sind zur Verbindung mehrerer übereinander oder nebeneinander angeordneter Signalaufnahme- und Informationseinheiten 1 vorgesehen. Die einzelnen Signalaufnahme- und Informationseinheiten 1 werden einzeln auf der Wand befestigt und vor der Montage durch die Steckkontakt- und Buchsenleisten 15, 16 jeweils miteinander verbunden. Die Anordnung der Signalaufnahme- und Informationseinheiten 1 kann wahlweise horizontal oder vertikal ausgerichtet werden und unter Verwendung einer entsprechenden Unterputz-Schalterabdeckung 3 werden die zusammengesteckten Signalaufnahme- und Informationseinheiten 1 abgedeckt.

Figur 4 zeigt die obere Platine 10, welche eine obere und untere Aussparung 17, 18 für größere elektronische Bauelemente aufweist und auf ihrer Oberseite in den jeweiligen Eckpunkten mit vier einzelnen Tastern 13 ausgestattet ist. Die Steckkontaktleisten 11 zum Verbinden mit der unteren Platine 6 befinden sich auf der Unterseite und weisen eine korrespondierende Anordnung zur unteren Platine 6 auf, so daß die obere Platine 10 nur in einer Position aufgesteckt werden kann. Darüber hinaus sind auf der Platine weitere elektronische Bauteile aufgelötet, welche in Verbindung mit der unteren Platine den Signalund Datenaustausch ermöglichen und in Verbindung mit einem Mikroprozessor 22 eine programmierbare Signalaufnahme- und Informationseinheit 1 bilden, welche jederzeit an die örtlichen Gegebenheiten und Funktionen durch eine entsprechende Programmierung angepaßt werden kann. Die Anordnung und Auswahl der elektronischen Bauteile auf den beiden Platinen 6, 10 erfolgt entsprechend der vorgesehenen Funktion und weichen in der Regel bis auf wenige identische Bauteile voneinander ab.

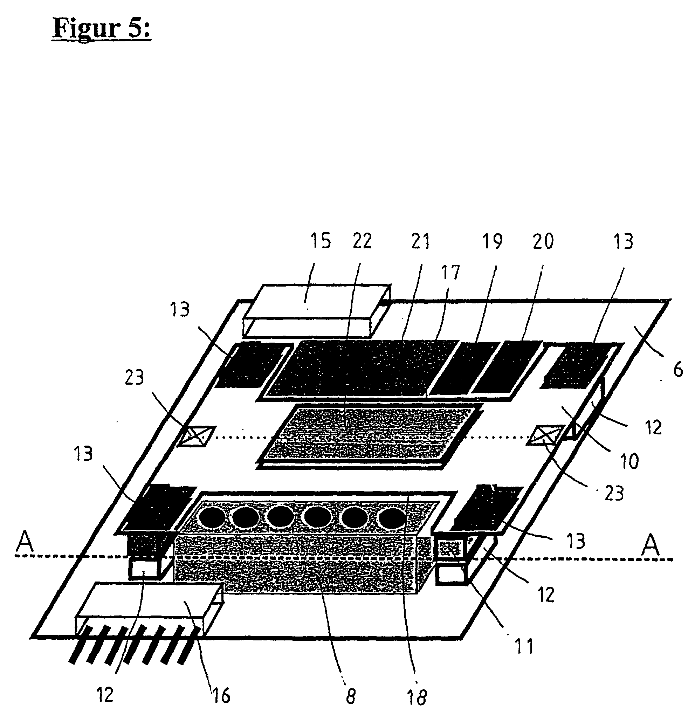

Figur 5 zeigt in einer perspektivischen Ansicht die zusammengesteckten Platinen 6, 10 ohne Schalterabdeckung und Wippe. Von der unteren Platine 10 ist am unteren und oberen Platinenrand diametral gegenüberliegend die Buchsenleiste 15 und Steckkontaktleiste 16 zur Verbindung mehrerer Signalaufnahme- und Informationseinheiten 1 untereinander angeordnet. Im Weiteren ist von der unteren Platine 6 die Klemmleiste 8 zum Einschrauben der Kabelverbindung und die vier in den Eckpunkten befindlichen Buchsenleisten 12 abgebildet. In den Buchsenleisten 12 sind die auf der Rückseite der oberen Platine 10 eingelöteten Steckkontaktleisten 11 korrespondierend eingesteckt und ermöglichen somit eine mechanische und elektrische Verbindung der beiden Platinen 6, 10 miteinander. In den vier Eckpunkten der oberen Platine 10 sind die Taster 13 auf der Platine aufgelötet, welche im Weiteren die Schaltfunktion auslösen, die durch die nicht dargestellte Wippe 5 betätigt werden. Die untere Aussparung 18 der oberen Platine 10 ermöglicht im Weiteren die Anordnung der Klemmleiste 8 auf der unteren Platine 6, welche gegenüber den sonstigen Bauelementen eine wesentlich größere Höhe aufweist. Die obere Aussparung 17 ermöglicht demgegenüber die Unterbringung von einzelnen elektronischen Bauteilen, welche ein zu tolerierendes Höhenmaß überschreiten und sind ebenfalls in der oberen Platine eingelötet. Im gezeigten Ausführungsbeispiel handelt es sich beispielsweise um einen Kondensator 19, eine Spule 20 und einen Transceiver 21. Ungefähr in der geometrischen Mitte der oberen Platine befindet sich ein Mikroprozessor 22, welcher eine freiprogrammierbare und jederzeit veränderbare Funktion der Signalaufnahme- und Informationseinheit 1 ermöglicht. An der linken und rechten äußeren Seitenkante der oberen Platine 10 befindet sich im Weiteren ein Drehpunkt 23 für die Wippe, damit diese bei einer Bewegung die oberen bzw. unteren Taster 13 betätigen kann.

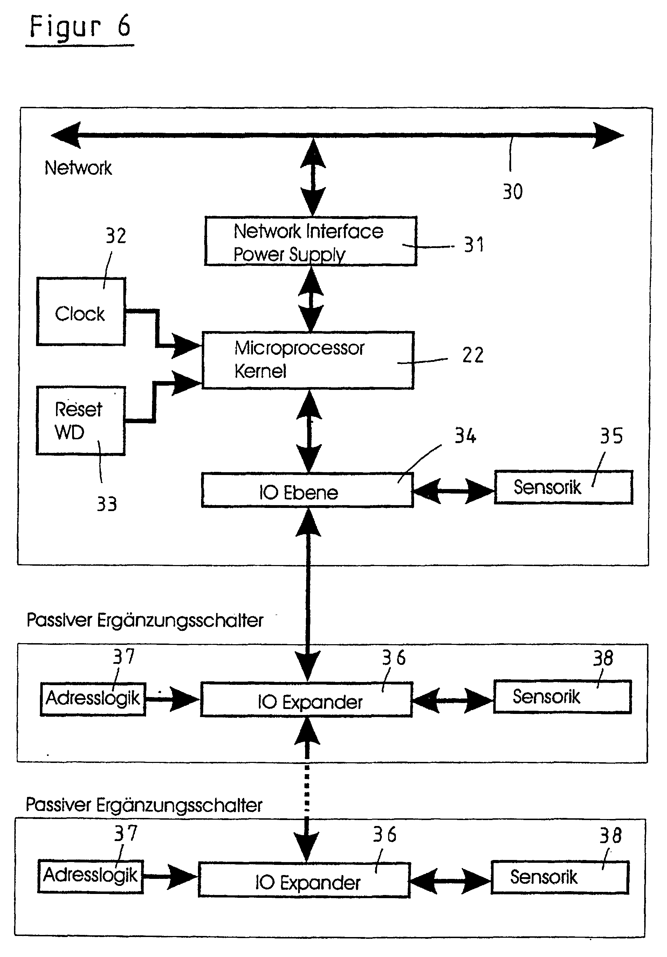

Figur 6 zeigt ein Blockschaltbild der in der Signalaufnahme- und Informationseinheit 1 integrierten elektronischen Schaltung. Über eine Draht-, Funk oder Infrarotverbindung wird ein Signal- und Datenaustausch mit dem LON-BUS 30 ermöglicht. Die elektronischen Schaltungen einer jeden Signalaufnahme- und Informationseinheit 1 sowie der korrespondierenden Signalempfangs- und Steuerungseinheiten weist zu diesem Zweck ein Interface und eine Spannungsversorgung 31 auf, welche im Weiteren unmittelbar mit den Mikroprozessor 22 verbunden ist, welcher durch einen Frequenzgeber 32 und einen Reset-Schalter 33 einerseits gesteuert bzw. neu gestartet werden kann. Der Mikroprozessor 22 ist über eine Input- und Outputschaltung 34 einerseits mit der Sensorik 35, das heißt den Tastern, Informationsdisplays, Sensoren, Meldeeinrichtungen etc. verbunden. Femer wird über die Input- und Outputschaltung 34 die Verbindung zur weiteren Ergänzungseinheiten ermöglicht, welche einen entsprechenden Input- und Outputexpander 36 eine hierzu notwendige Adresslogig 37 sowie eine eigene Sensorik 38 aufweisen. Weitere Ergänzungseinheiten sind analog aufgebaut.

### Bezugszeichenliste

- 1: Signalaufnahme- und Informationseinheit
- 2: Flächenschalter
- 3: Unterputz-Schalterabdeckung
- 4: Aussparung
- 5: Wippe
- 6: Platine
- 7: Aussparung
- 8: Klemmleiste
- 9: Auskragung
- 10: Platine
- 11: Steckkontaktleiste
- 12: Buchsenleiste
- 13: Taster
- 14: Wand
- 15: Buchsenleiste
- 16: Steckerleiste
- 17: Aussparung
- 18: Aussparung
- 19: Kondensator
- 20: Spule
- 21: Transceiver
- 22: Mikroprozessor
- 23: Drehpunkt
- 30: LON-BUS
- 31: Interface und Netzteil
- 32: Frequenzgeber
- 33: Reset-Schalter
- 34: Input-Outputschaltung
- 35: Sensorik
- 36: Input-Outputexpander
- 37: Adresslogig
- 38: Sensorik

## Patentansprüche

1. Installationseinrichtung, insbesondere für eine dezentrale Gebäudetechnik, mit zumindest einer Signalaufnahme- und Informationseinheit (1) und zumindest einer Signalempfangs- und Steuerungseinheit, zwischen denen ein Signalaustausch stattfindet,
**dadurch gekennzeichnet,**
**daß** wenigstens die Signalaufnahme- und Informationseinheit (1) unter Beibehaltung der herkömmlichen Abmessungen von Unterputz-Schalterabdeckungen (2) zur Aufputzmontage vorgesehen ist.

2. Installationseinrichtung nach Anspruch 1,
**dadurch gekennzeichnet,**
**daß** die Bauteile der Signalaufnahme- und Informationseinheiten (1) zumindest auf einer unterhalb der Schalterabdeckung befestigten Platine (6,10) oder innerhalb eines kompakten Bauteils, z.B. der Hybridtechnik, angeordnet sind.

3. Installationseinrichtung nach Anspruch 1 oder 2,
**dadurch gekennzeichnet,**
däß mehrere nebeneinander- oder übereinanderliegende Signalaufnahme- und Informationseinheiten (1) oder mehrere Signalempfangs- und Steuerungseinheiten untereinander durch Steckkontakte miteinander verbunden sind, welche in Form einer Steck- bzw. Buchsenkontaktleiste (15, 16) an zwei diametral gegenüberliegenden Seitenkanten in der Ebene der Platinen (6, 10) angeordnet sind.

4. Installationseinrichtung nach einem oder mehreren der Ansprüche 1 - 3,
**dadurch gekennzeichnet,**
**daß** die Signalaufnahme- und Informationseinheiten (1) ausschließlich . mit Niederspannung betreibbar sind.

5. Installationseinrichtung nach einem oder mehreren der Ansprüche 1 - 4,
**dadurch gekennzeichnet,**
**daß** die Bauteile der Signalaufnahme- und Informationseinheiten (1) auf einer ersten Platine (6) zur Wandmontage innerhalb der Schalterrahmenabdeckung (2) und einer zweiten Platine (10) unterhalb der Schalterabdeckung (5) angeordnet sind, welche durch zumindest eine, vorzugsweise vier in den Eckpunkten angeordneten, Steckkontaktleisten (11) bzw. Buchsenleisten (12) miteinander verbunden sind, wobei die Steckkontaktleisten (11) und korrespondierenden Buchsenkontaktleisten (12) senkrecht zur jeweiligen Platine (6, 10) angeordnet sind.

6. Installationseinrichtung nach einem oder mehreren der Ansprüche 1 - 5,
**dadurch gekennzeichnet,**
**daß** die Signalaufnahme- und Informationseinheit (1) wenigstens eine programmierbare Mikroprozessorschaltung (22) aufweist, welche zur Erfassung, Anzeige und Weiterleitung von Meßwert-, Steuer-, optischen und akustischen Informations-, und/oder Überwachungssignale sowie zur Auswertung der vorhanden Signale vorgesehen ist.

7. Installationseinrichtung nach einem oder mehreren der Ansprüche 1 - 6,
**dadurch gekennzeichnet,**
**daß** die Signalaufnahme- und Informationseinheiten (1) aus Schaltern, insbesondere Geräteschaltern, Informationsdisplays, Raumtemperatur-, Klimareglern, Personenruf- und Meldeeinrichtungen, Alarmanlagensensoren oder -gebern, Buseingängen, Sensoren, Dimmern, Anschlußdosen, Zählwerken oder Personenindentifikationsgeräten besteht.

8. Installationseinrichtung nach einem oder mehreren der Ansprüche 1 - 7,
**dadurch gekennzeichnet,**
**daß** die Signalempfangs- und Steuerungseinheit zum Anschluß an Heizungsund Brauchwasseranlagen, Lüftungsanlagen mit Wärmerückgewinnung, Solar-, Licht-, Alarmanlagen, Schwimmbadsteuerungen, technische Nutzgeräte sowie akustischen oder optischen Warn- und Meldeeinrichtungen vorgesehen ist.

9. Installationseinrichtung nach einem oder mehreren der Ansprüche 1 - 8
**dadurch gekennzeichnet,**
**daß** die Signalaufnahme- und Informationseinheiten (1) mehrere Funktionen in einer Einheit aufweisen.

10. Intallationseinrichtung nach einem oder mehreren der Ansprüche 1 - 9
**dadurch gekennzeichnet,**
**daß** eine Signalaufnahme- und Informationseinheit (1) einer oder mehreren Signalempfangs- und Steuerungseinheiten zugeordnet ist und/oder daß eine Signalempfangs- und Steuerungseinheit einer oder mehreren Signalaufnahme- und Informationseinheit (1) zugeordnet ist

11. Installationseinrichtung nach einem oder mehreren der Ansprüche 1 - 10,
**dadurch gekennzeichnet,**
**daß** eine individuelle und veränderbare Programmierung der Zuordnung zwischen einer Signalaufnahme- und Informationseinheit (1) und einer Signalempfangs- und Steuerungseinheit vorgesehen ist.

12. Installationseinrichtung nach einem oder mehreren der Ansprüche 1 - 11,
**dadurch gekennzeichnet,**
**daß** die weiter voneinander entfernten Signalaufnahme- und Informationseinheiten (1) sowie Signalempfangs- und Steuerungseinheiten über eine Draht-, Funk- oder Infrarotverbindung, ein Glasfaserkabel oder eine Power-Line untereinander verbunden sind.

13. Installationseinrichtung nach einem oder mehreren der Ansprüche 1 - 12,
**dadurch gekennzeichnet,**
**daß** die weiter voneinander entfernten Signalaufnahme- und Informationseinheiten (1) sowie Signalempfangs- und Steuerungseinheiten über einen, vorzugsweise 2-adrigen seriellen, LON-BUS (Local Operating Network) miteinander verbunden sind und über ein standardisiertes LONTALK-Protokoll Daten und Signale austauschen.

14. Installationseinrichtung nach einem oder mehreren der Ansprüche 1 - 13,
**dadurch gekennzeichnet,**
**daß** die Signalaufnahme- und Informationseinheiten (1) über Anschlußeinrichtungen, insbesondere den vorhandenen LON-BUS-Verbindungen, mit Computeranlagen und/oder Telefon- bzw. Datennetzen verbindbar sind.

15. Installationseinrichtung nach einem oder mehreren der Ansprüche 1 - 14,
**dadurch gekennzeichnet,**
**daß** unter Berücksichtigung der einprogrammierten Funktionen und ermittelten Meßwerte bzw. vorhandenen Signalen einzelner Signalempfangs- und Informationseinheiten (1) eine dezentrale bereichsübergreifende Steuerung der gesamten Haustechnik erfolgt.

16. Installationseinrichtung nach einem oder mehreren der Ansprüche 1 - 15,
**dadurch gekennzeichnet,**
**daß** der LON-Bus zumindest ein Spannungsversorgungsmodul und/oder zumindest einen BUS-Verstärker aufweist.

## Claims

1. An installation device, in particular, for decentralized building systems, with at least one signal pick-up and information unit (1) and at least one signal receiving and control unit, wherein a signal exchange takes place between said units,
**characterized by** the fact
that at least the signal pick-up and information unit (1) is designed for being surface-mounted although its dimensions correspond to the conventional dimensions of flush-mounted switch covers (2).

2. The installation device according to Claim 1,
**characterized by** the fact
that the components of the signal pick-up and information units (1) are arranged on at least one printed circuit board (6, 10) that is mounted underneath the switch cover or within a compact component, e.g., in accordance with the hybrid technology.

3. The installation device according to Claim 1 or 2,
**characterized by** the fact
that several signal pick-up and information units (1) or several signal receiving and control units which lie adjacent to or on top of one another are connected to one another by means of plug-type contacts that are arranged on two diametrically opposite lateral edges in the plane of the printed circuit boards (6, 10) in the form of a plug-and-socket contact strip (15, 16).

4. The installation device according to at least one of Claims 1-3,
**characterized by** the fact
that the signal pick-up and information units (1) can only be operated with a low voltage.

5. The installation device according to at least one of Claims 1-4,
**characterized by** the fact
that the components of the signal pick-up and information units (1) are arranged on a first printed circuit board (6) designed for being wall-mounted within the switch frame cover (2) and a second printed circuit board (10) underneath the switch cover (5) which are connected to one another by means of at least one, preferably four plug contact strips (11) and socket strips (12) arranged in the corner points, wherein the plug contact strips (11) and the corresponding socket contacts strips (12) are arranged perpendicular referred to the respective printed circuit board (6, 10).

6. The installation device according to at least one of Claims 1-5,
**characterized by** the fact
that the signal pick-up and information unit (1) contains at least one programmable microprocessor circuit (22) that serves for acquiring, displaying and forwarding measuring value signals, control signals, optical and acoustical information and/or monitoring signals, as well as for evaluating the respective signals.

7. The installation device according to at least one of Claims 1-6,
**characterized by** the fact
that the signal pick-up and information units (1) consist of switches, in particular, appliance switches, information displays, room temperature/climate controllers, paging and messaging devices, alarm system sensors or transmitters, bus inputs, sensors, dimmers, wall outlets, counters or person identification devices.

8. The installation device according to at least one of Claims 1-7,
**characterized by** the fact
that the signal receiving and control unit is designed for being connected to heating and service water systems, ventilation systems with heat recovery, solar systems, lighting systems, alarm systems, swimming pool controls, technical utility appliances, as well as acoustical or optical warning and messaging devices.

9. The installation device according to at least one of Claims 1-8,
**characterized by** the fact
that the signal pick-up and information units (1) combine several functions in one unit.

10. The installation device according to at least one of Claims 1-9,
**characterized by** the fact
that one signal pick-up and information unit (1) is assigned to one or more signal receiving and control unit(s) and/or that one signal receiving and control unit is assigned to one or more signal pick-up and information unit(s) (1).

11. The installation device according to at least one of Claims 1-10,
**characterized by** the fact
that the allocation between a signal pick-up and information unit (1) and a signal receiving and control unit can be individually and variably programmed.

12. The installation device according to at least one of Claims 1-11,
**characterized by** the fact
that signal pick-up and information units (1) and signal receiving and control units which are arranged greater distances from one another are connected by means of a wire, radio or infrared connection, a fiber-optic cable or a power line.

13. The installation device according to at least one of Claims 1-12,
**characterized by** the fact
that signal pick-up and information units (1) and signal receiving and control units which are arranged greater distances from one another are connected via a preferably 2-conductor serial LON BUS (Local Operating Network) and exchange data and signals in the form of a standardized LONTALK protocol.

14. The installation device according to at least one of Claims 1-13,
**characterized by** the fact
that the signal pick-up and information units (1) can be connected to computer systems and/or telephone and data networks by means of connecting devices, in particular, the existing LON BUS connections.

15. The installation device according to at least one of Claims 1-14,
**characterized by** the fact
that a decentralized, comprehensive control of all building systems is realized based on the programmed functions and determined measuring values, as well as the signals delivered by individual signal receiving and information units (1).

16. The installation device according to at least one of Claims 1-15,
**characterized by** the fact
that the LON bus contains at least one voltage supply module and/or at least one BUS amplifier.

## Revendications

1. Dispositif d'installation, en particulier destiné à une technologie de bâtiment décentralisée, ayant au moins une unité d'enregistrement de signal et une unité d'informations (1) et au moins une unité réceptrice de signal et une unité de commande, entre lesquelles a lieu un échange de signaux,
**caractérisé en ce que**,
au moins l'unité d'enregistrement de signal et d'informations (1) est prévue pour un montage apparent en respectant les dimensions classiques des caches de circuit encastré (2).

2. Dispositif d'installation selon la revendication 1,
**caractérisé en ce que**,
les composants des unités d'enregistrement de signal et d'informations (1) sont au moins disposés sur une platine (6, 10) fixée au-dessous du cache de circuit, ou bien à l'intérieur d'un composant compact, par exemple issu de la technologie hybride.

3. Dispositif d'installation selon la revendication 1 ou 2,
**caractérisé en ce que**,
plusieurs unités d'enregistrement de signal et d'informations disposées côté à côte ou l'une sur l'autre (1) ou plusieurs unités réceptrices de signal et de commande l'une sous l'autre sont reliées l'une à l'autre par des contacts de fiche qui sont disposés sous la forme d'une réglette de contacts mâles ou femelles (15, 16) sur deux bords latéraux diamétralement opposés dans le plan des platines (6, 10).

4. Dispositif d'installation selon l'une ou plusieurs des revendications 1 à 3,
**caractérisé en ce que**,
les unités d'enregistrement de signal et d'informations (1) peuvent être exploités exclusivement avec une basse tension.

5. Dispositif d'installation selon l'une ou plusieurs des revendications 1 à 4,
**caractérisé en ce que**,
les composants des unités d'enregistrement de signal et d'informations (1) sont disposées sur une première platine (6) destinée à un montage mural à l'intérieur du cache d'encadrement du circuit (2) et sur une deuxième platine (10) sous la couverture de circuit (5), lesquelles platines sont reliées entre elles par au moins une, ou de préférence quatre, réglettes de contacts mâles (11) ou réglettes de contacts femelle (12) disposées dans les points d'angle, les réglettes de contacts mâles (11) et les réglettes de contacts femelles correspondantes (12) sont disposées perpendiculairement à la platine respective (6, 10).

6. Dispositif d'installation selon l'une ou plusieurs des revendications 1 à 5,
**caractérisé en ce que**,
l'unité d'enregistrement de signal et d'informations (1) présente au moins un circuit à microprocesseur programmable (22), qui est prévu pour détecter, afficher et transmettre des signaux optiques et acoustiques d'informations et/ou de contrôle de valeurs de mesure, de commande, ainsi que pour évaluer les signaux présents.

7. Dispositif d'installation selon l'une ou plusieurs des revendications 1 à 6,
**caractérisé en ce que**,
les unités d'enregistrement de signal et d'informations (1) sont constituées de circuits en particulier de circuits d'appareil, d'affichages d'information, de régulateurs climatiques de température ambiante, de dispositifs d'appel de personnes et de signalisation, de détecteurs ou capteurs d'installations d'alarme, d'entrées de bus, de détecteurs, de gradateurs de lumière, de prises de courant, de minuteries, ou d'appareils d'identification de personnes.

8. Dispositif d'installation selon l'une ou plusieurs des revendications 1 à 7,
**caractérisé en ce que**,
l'unité réceptrice de signal et de commande est prévue pour être branchée sur des installations de chauffage et d'eau sanitaire, des installations de ventilation avec récupération de la chaleur, des installations solaires, des éclairages, des alarmes, des commandes de piscines, des appareils techniques utilitaires ainsi que des dispositifs d'alerte et de signalisation.

9. Dispositif d'installation selon l'une ou plusieurs des revendications 1 à 8,
**caractérisé en ce que**,
les unités d'enregistrement de signal et d'informations (1) présentent plusieurs fonctions dans une seule unité.

10. Dispositif d'installation selon l'une ou plusieurs des revendications 1 à 9,
**caractérisé en ce que**,
une unité d'enregistrement de signal et d'informations (1) est associée à une ou plusieurs unités réceptrices de signal et de commande et/ou **en ce qu'**une unité réceptrice de signal et de commande est associée à une ou plusieurs unités d'enregistrement de signal et d'informations (10).

11. Dispositif d'installation selon l'une ou plusieurs des revendications 1 à 10,
**caractérisé en ce que**,
il est prévu une programmation individuelle et modifiable de l'association entre une unité d'enregistrement de signal et d'informations (1) et une unité réceptrice de signal et de commande.

12. Dispositif d'installation selon l'une ou plusieurs des revendications 1 à 11,
**caractérisé en ce que**,
les unités d'enregistrement de signal et d'informations (1) ainsi que les unités réceptrices de signal et de commande, très éloignées les unes des autres, sont reliées entre elles par une liaison filaire, radioélectrique ou infrarouge, un câble à fibres optiques, ou une ligne d'alimentation.

13. Dispositif d'installation selon l'une ou plusieurs des revendications 1 à 12,
**caractérisé en ce que**,
les unités d'enregistrement de signal et d'informations (1) ainsi que les unités réceptrices de signal et de commande, très éloignées les unes des autres, sont reliées entre elles par un bus de réseau local d'exploitation (Local Operating Network (LON)), sériel de préférence à deux conducteurs et échangent des données et des signaux par l'intermédiaire d'un protocole normalisé LONTALK.

14. Dispositif d'installation selon l'une ou plusieurs des revendications 1 à 13,
**caractérisé en ce que**,
les unités d'enregistrement de signal et d'informations (1) peuvent être reliées à des installations informatiques et/ou à des réseaux téléphoniques ou de données par des dispositifs de raccordement, en particulier les raccords LON-BUS existants.

15. Dispositif d'installation selon l'une ou plusieurs des revendications 1 à 14,
**caractérisé en ce que**,
une commande décentralisée recouvrant les domaines de toute la domotique est réalisée en prenant en compte les fonctions programmées dans celle-ci et les valeurs de mesure transmises ou les signaux existants des unités réceptrices de signal et d'informations individuelles (1).

16. Dispositif d'installation selon l'une ou plusieurs des revendications 1 à 15,
**caractérisé en ce que**,
le bus LON présente au moins un module d'alimentation en tension et/ou au moins un amplificateur de bus.
